# EUROPEAN PATENT APPLICATION

(11) **EP 3 382 057 A1**
(43) Date of publication of application: **03.10.2018**
(21) Application number: 17382155.4
(22) Date of filing: 29.03.2017
(51) Int. Cl.: C23C 14/24, C23C 14/56

(54) **APPARATUS FOR DEPOSITING UNDER ULTRA-HIGH VACUUM CONDITIONS**

(71) Applicant: Bihurcrystal, S.L., 20009 San Sebastian (ES)
(72) Inventor: MICCIO STEFANCIK, Luis Alejandro, E-20009 San Sebastián (ES); GONZÁLEZ MORENO, Rubén, E-20009 San Sebastián (ES)

(57) **Abstract**

The present invention relates to an apparatus for depositing one or more materials (Mᵢ ) on one or more substrates (Sᵢ ) under ultra-high vacuum conditions comprising a feed compartment (1) defining a first space (Eₐ ) therein and comprising a first housing (1.1) for the at least one material (Mi), a first heating element (2) for the sublimation of the at least one material (Mᵢ ) housed in the feed compartment (1), an ultra-high vacuum chamber (6) defining a second space (E_{c} ) therein, wherein the ultra-high vacuum chamber (6) comprises a second housing (4) for at least one substrate (Si) and a pump (5) in communication with the second space (E_{c} ) of the chamber (6) for producing ultra-high vacuum in said second space (E_{c} ).The feed compartment (1) comprises a window (1.2) closed by at least one diffusion membrane (3) for the at least one material (Mᵢ ), said diffusion membrane (3) comprises two opposite faces, a first face in contact with the first space (Eₐ ) of the feed compartment (1) and a second face in contact with the second space (E_{c} ) of the ultra-high vacuum chamber (6).

## Description

### Object of the Invention

The present invention relates to nanotechnology techniques that are applied in the industry and research. Particularly, it relates to the deposition of material on a substrate under ultra-high vacuum conditions, wherein the deposited material is one or a few atoms thick. More particularly, the present invention provides an apparatus for depositing one or more materials on one or more substrates under ultra-high vacuum conditions. Furthermore, the present invention provides a method for depositing one or more materials on one or more substrates under ultra-high vacuum conditions by means of said apparatus.

### Background of the Invention

The so-called Knudsen cells (K-cells) are used today in nanotechnology, and more particularly in the sublimation of materials. This K-cell uses the principle of molecular effusion demonstrated by Knudsen in 1909. In a K-cell, the material to be deposited is heated until reaching the desired vapor pressure in an isothermal capsule or receptacle with an exhaust opening. This gives rise to a ballistic deposition of the material under ultra-high vacuum (UHV) conditions on a specific substrate in the form of a beam. If desired, this beam can be collimated (for example, by means of using electric fields, among other methods) to allow a specific degree of control over the beam projection direction. The usefulness thereof lies in its capacity to deposit a material on a substrate in a controlled and reproducible manner, in one or more monolayers. In turn, it is capable of producing also in a controlled manner epitaxy films or layers (ordered layers wherein the nature of the adsorbate order is related to the substrate order), which gave rise to the technique known as Molecular Beam Epitaxy (MBE).

MBE is currently used in nanotechnology and in semiconductor manufacture and consists of growing atomically precise crystalline layers of most semiconductor materials. On the other hand, MBE is also used in surface science for depositing one or more layers of organic (or inorganic) molecules on monocrystalline substrates. In these cases, the adsorbed molecules form structures with specific properties that can be studied through UHV (ultra-high vacuum) techniques, such as for example, scanning tunneling microscopy (STM), X-ray photoelectron spectroscopy (XPS) and angleresolved photoelectron spectroscopy, among others.

Since the beginning of the 1960s, K-cells have been used in devices and methods covering applications ranging from semiconductor growth to vapor-phase reactions, among many others. However, since the beginning of the 1990s, several attempts have been made to reduce the impact of impurities on the deposition process, such as by adding additional exhaust mechanisms or moving cells, for example. Attempts have also been made to solve the problem relating to the spontaneous sublimation of materials by means of low-temperature cells.

A typical K-cell comprises a crucible (usually made of boron nitride, quartz or tungsten, among others), a filament for heating said crucible (usually made of tantalum or tungsten), and metal supports (made of copper or titanium) connecting the structure to a part for coupling to the UHV chamber. With this configuration, the angle at which the atom beam is projected and the distance of the cell can usually be configured and are chosen according to the needs of the experiment to be conducted.

Materials are generally deposited on substrates under ultra-high vacuum conditions through a Knudsen-type cell. This deposition process requires an *in-situ* purification in which the cell is heated under ultra-high vacuum conditions to cause the sublimation of the material along with its impurities until these impurities are completely removed (before starting the substrate deposition process). However, this method is not valid for every material, the *in-situ* purification becomes impossible in those cases in which the impurities sublimate in the same temperature range as the material itself. Raising the temperature to cause the sublimation of the impurities also causes the sublimation of the material to be deposited, so the material to be deposited is completely or partially consumed when the purification phase ends, which prevents continuing with the deposition process as there is not enough purified material available.

Likewise, those materials the sublimation temperatures of which at the working pressure are close to room temperature sublimate spontaneously without possible purification or control.

To address this problem, a technique known as pervaporation of a material flow from the liquid phase to the vapor phase through a porous membrane which requires the deposition material to be contained in the liquid phase is known in the state of the art. In particular, pervaporation has been used in high vacuum (10-5 mbar) for mass spectrometry, which gave rise to the membrane introduction mass spectrometry (MIMS) technique.

Another technique known in the state of the art is chromatography which uses the principle of selective retention (through differences in the partition coefficient of compounds in a stationary phase) for separating the components of a mixture. The stationary phase in chromatographic techniques is therefore a fluid which contains the mixture to be separated and is in turn conducted through a sheet of paper or thin layers (planar chromatography), or through columns (liquid chromatography, gas chromatography or supercritical fluid chromatography). Taking into account that most materials used in chromatography are not compatible with UHV conditions, the presence of a trawl phase (stationary phase) as well as the completely different nature of the material flow make the use thereof in UHV conditions impossible. The main difference with the present invention lies in the nature of the process: under UHV conditions, the flow has a ballistic nature given that the continuum hypotheses are not verified, there is no pressure gradient causing movement through a column or filter.

Given the difficulties in depositing the material under UHV conditions and in preventing the deposition of impurities contained in the original material, how the present invention solves the aforementioned problems is shown below.

### Description of the Invention

The present invention proposes a solution to the preceding problems, among others, by means of an apparatus for depositing one or more materials on one or more substrates under ultra-high vacuum conditions according to claim 1 and a method for depositing one or more materials on one or more substrates under ultra-high vacuum conditions according to claim 15. The dependent claims define the preferred embodiments of the invention.

A first inventive aspect provides an apparatus for depositing one or more materials on one or more substrates under ultra-high vacuum conditions, characterized in that it comprises:
- a feed compartment defining a first space therein and comprising a first housing for the at least one material,
- a first heating element for the sublimation of the at least one material housed in the feed compartment,
- an ultra-high vacuum chamber defining a second space therein, wherein the ultra-high vacuum chamber comprises a second housing for at least one substrate,
- a pump in communication with the second space of the chamber for producing ultra-high vacuum in said second space,
wherein
the feed compartment comprises a window closed by at least one diffusion membrane for the at least one material, said diffusion membrane comprises two opposite faces, a first face in contact with the first space of the feed compartment and a second face in contact with the second space of the ultra-high vacuum chamber.

Throughout the entire document, ultra-high vacuum conditions will be understood as pressure conditions below 10⁻⁷ mbar.

The presence of at least two spaces, separated from one another by means of a diffusion membrane, advantageously allows delaying the effective effusion of materials (without having to cool or change said materials), in addition to causing a molecular mass-dependent separation when the deposition material contains other materials considered as impurities.

The present apparatus advantageously allows controlling the material to be deposited through the membrane, such that the deposited material will have a high purity as a result even though the material to be sublimated has impurities. Both the material flow during deposition and the material composition can be controlled by the user by means of the suitable selection of physical membrane characteristics (pore size, thickness and tortuosity).

The first heating element advantageously allows increasing the temperature in the feed compartment to thereby cause the sublimation of the material or materials arranged inside said compartment.

Furthermore, the present invention uses materials which are advantageously compatible with the UHV conditions. In other words, the fact that the apparatus is formed by materials compatible with UHV conditions allows the materials of the components of the apparatus to not sublimate or emit molecules at the same time as the material object of sublimation, and furthermore to not release gases increasing the pressure in the work space. Nevertheless and unlike the state of the art, the present invention does not require a stationary phase for eliminating impurities.

The presence of a pump in communication with the inside of the chamber of the present apparatus allows the desired ultra-high vacuum conditions to be obtained according to the object of the present invention.

The present configuration of the first and second spaces separated by a diffusion membrane furthermore causes the effusion of the material object of deposition to occur in an effective manner, i.e., causes the sublimated material (in the form of gas) which is under pressure inside the feed compartment to be exhausted from said compartment towards the second space by means of the diffusion membrane.

There are two temperatures influencing the effusion process, the temperature in the space where the material is housed, i.e., the inside of the feed compartment, and the temperature of the diffusion membrane the material will go through. On one hand, the temperature in the feed compartment directly influences the number of particles of material transitioning to the vapor phase, and therefore the pressure in said space. On the other hand, the temperature of the diffusion membrane influences the effective diffusion coefficient, and therefore the material flow through said diffusion membrane. Therefore, according to one embodiment a controlled material flow is achieved through a control loop acting on the temperatures in the feed compartment and in the diffusion membrane.

The control of the temperature in the membrane can be independent of the temperature in the feed compartment for the purpose of acting mainly on the diffusion parameter and therefore on the flow rate of the molecules to be transferred to the ultra-high vacuum compartment for deposition.

In a particular embodiment, the at least one diffusion membrane is a porous material with interconnected pores. In a more particular embodiment, the pores of the at least one diffusion membrane have a size between 10 nm and 400µm.

Advantageously, under these conditions the molecules going through the membrane have access to the inner space of the chamber with a tortuous passage through same. The characteristic pore size must be selected depending on the size of the molecules of the material to be deposited.

In a particular embodiment, the at least one diffusion membrane is a Knudsen diffusion membrane for the at least one material.

The arrangement of a Knudsen diffusion membrane, advantageously, and given the pressure conditions in the feed compartment, forces the materials going through said membrane to diffuse through it such that the mean free path of the molecules is much larger than free path in the diffusion membrane, so this diffusive process is a Knudsen-type diffusive process.

Under these conditions, the effective diffusion coefficient is greater for materials with lower molecular weight. In other words, the membrane performs discrimination based on molecular weight such that the mass flow rate of a specific molecule is inversely proportional to its molecular mass. When the impurities have a molecular weight higher than the molecular weight of the material to be deposited, the Knudsen membrane drastically reduces the passage of the impurities while favoring the passage of the molecules of interest to be deposited.

Therefore, the technical effect achieved through a Knudsen diffusion membrane consists of delaying the effusion of the components of the material with higher molecular weight so that the material diffused with higher mass flow rate is what is to be deposited on the substrate. It has been observed that control over the ratio of mass flow rates depends on the temperature of the membrane, hence the interest in an embodiment for maintaining control over said temperature.

In another particular embodiment, the at least one membrane is made of an adsorbent material such that said at least one membrane is adapted to adsorb the at least one material from the first space and to desorb said material into the second space.

Advantageously, factors relating to the affinity between the molecules passing through the membrane and the material of the membrane intervene in this adsorption-desorption process regardless of the kinetic mechanisms of gases which act on the Knudsen membrane, and therefore add an additional factor for selecting the molecules passing from one membrane side to another. It is of interest to use materials with impurity adsorption capacity but not giving rise to subsequent desorption of the impurities except in processes of recovering the membrane after use, for example raising its temperature. If this adsorption does not occur or occurs to a lesser extent for the material to be deposited the selection mechanisms sought by the membrane then increase.

In a particular embodiment, the apparatus comprises a plurality of diffusion membranes arranged in series, wherein there is a gap between consecutive membranes.

A plurality of diffusion membranes arranged in series advantageously provides the effective effusion of the materials, as mentioned above, without having to cool or change said materials, and furthermore provides a molecular mass-dependent separation in a mixture of several materials. This selection is established depending on the concentrations of molecules of different molecular weight existing on the membrane side before they pass through same, so it has been found that the result is different from the use of a stack of the same membranes, without any inter-membrane space.

In another particular embodiment, the apparatus comprises a plurality of diffusion membranes arranged in series, wherein each membrane is in contact with the adjacent membrane.

Advantageously, features relating to tortuosity and characteristic pore size can be different in each of the membranes arranged in series such that it is possible, for example, to progressively increase or reduce the porosity. The equivalent of this configuration with a single membrane would be to arrange a membrane with a gradient of properties, i.e., porosity, tortuosity, or others, but with a simpler manufacturing method.

In a more particular embodiment, one or more groups of diffusion membranes are arranged parallel to one another. Parallel arrangement must be interpreted in the broadest sense, that is, the sublimated material can pass either through one membrane or through another, but as an excluding alternative, and it does not necessarily require the membranes to be oriented according to parallel planes. The membranes could be parallel when a membrane is arranged next to the other membrane but they are both arranged with a specific relative angulation.

In a particular embodiment, the feed compartment is housed inside the chamber.

In another particular embodiment, the feed compartment is a crucible. Throughout the entire document, a crucible is understood as a receptacle adapted to support high-temperature elements. Nevertheless, the fact that the feed compartment is a crucible advantageously allows said feed compartment to be able to be heated at high temperatures to thereby achieve the sublimation of the materials arranged therein.

In a particular embodiment, the first heating element is a resistance coupled to a power supply source.

In a more particular embodiment, the at least one diffusion membrane is an inert membrane.

An inert diffusion membrane is understood as a membrane the membrane-forming materials of which do not interact chemically or physically with the materials, such that the effects on the material flow only depend on the temperatures in the feed compartment, on the temperature of said diffusion membrane, on the molar mass of the materials and on porosity, thickness and tortuosity of said diffusion membrane. An example of physical interaction can be electrostatic interaction trapping some or all molecules.

Advantageously, membranes of this type prevent any type of classification of the molecules going through said membranes other than by their molecular weight.

In another particular embodiment, the at least one diffusion membrane is an active membrane.

An active diffusion membrane is understood as a membrane the membrane-forming materials and/or outer surfaces of which chemically and/or physically interact with the materials object of deposition. Unlike inert diffusion membranes, for active diffusion membranes there are other parameters for controlling the effect of diffusion, depending on the type of interaction between said membrane and the material to be diffused.

In a more particular embodiment, the at least one active diffusion membrane is made of an inert material with active particles.

An active diffusion membrane made of an inert material with active particles is understood as composite membranes where the matrix is inert and said matrix has embedded active particles having catalytic activity for one or more chemical reactions of the material object of deposition. This catalytic activity can take place, for example, in membranes formed by foams of inert materials containing active particles, or also, for example, in membranes formed by an inert material, such as glass containing embedded catalytic particles, for example.

In a more particular embodiment, the inert material of the at least one active diffusion membrane is a material from the following list: copper, tantalum, gold, silver or titanium oxide; or a combination thereof.

In another particular embodiment, the at least one active diffusion membrane is made of a material with the capacity to show physical interaction.

An active diffusion membrane formed by a material with physical interaction is understood as a membrane the material or materials of which or the added filler thereof have physical-type intermolecular forces with the material object of deposition. For example, diffusion membranes or fillers forming hydrogen bridge bonds, dipole-dipole or Van der Waals bonds with the material object of deposition.

Advantageously, membranes of this type incorporate impurity retention means making use of bonding mechanisms which trap specific target molecules, acting in collaboration with the molecular weight-dependent selective diffusion.

In a particular embodiment, the feed compartment further comprises a first sensor configured for detecting temperature in the first space, i.e., in said feed compartment.

In a particular embodiment, the at least one diffusion membrane further comprises a second sensor configured for detecting temperature in said at least one membrane.

As a result of these first and second sensors, temperatures influencing the effusion process, i.e., the temperature in the feed compartment and the temperature of the diffusion membrane, can advantageously be controlled.

In a more particular embodiment, the at least one diffusion membrane further comprises a second heating element configured for desorbing the at least one material.

The presence of a second heating element efficiently contributes both to the absorption of the material and the desorption of said material from the surface of the diffusion membrane towards the space under ultra-high vacuum conditions. As a result of this second heating element, the desorption of the material can be selectively controlled by managing the mass flow rate of the material to be deposited that is to be introduced into the chamber. For example, the second heating element can be light, electric fields and/or magnetic fields.

In a more particular embodiment, the second heating element is a laser device arranged to strike on the at least one membrane.

In a particular embodiment, the second space located in the chamber comprises a third heating element configured for heating the at least one substrate.

Arranging a third heating element allows increasing the temperature of the substrate so that, once the material has been deposited on the substrate, said heating will advantageously allow the particles of the already deposited material to rearrange themselves, thereby forming a monolayer or multilayer structure on the substrate in accordance with the user's objective.

Compared to the fractional distillation of the state of the art, the present invention allows the apparatus to work in any orientation without requiring convective or gravitational effects. Furthermore, as mentioned above, the present apparatus allows the possibility of performing selective catalysis or retention by simply changing the material of the diffusion membrane of said apparatus.

On the other hand, the advantages of the present invention compared to MIMS lie in its capacity for directing and collimating, if desired, the material flow and depositing said material on the substrate in a quantitative and reproducible manner. Likewise, the present invention is not limited to introducing the materials under ultra-high vacuum conditions, but furthermore allows the selective retention of said materials and controlled chemical reaction by means of the catalysis of the membrane itself.

A second inventive aspect provides a method for depositing one or more materials on one or more substrates under ultra-high vacuum conditions by means of the apparatus according to the first inventive aspect, characterized in that it comprises the following steps:
a) placing one or more deposition materials in the housing of the feed compartment,
b) placing one or more substrates in the housing of the ultra-high vacuum chamber,
c) applying vacuum in the chamber by means of the pump,
d) heating the feed compartment by means of the first heating element until reaching the sublimation temperature of one or more materials in the first space,
e) maintaining the sublimation temperature for a deposition time until the diffused material is projected onto one or more substrates.

In a particular embodiment, the at least one diffusion membrane further comprises a second sensor configured for detecting temperature in said at least one membrane and a second heating element configured for desorbing the at least one material, wherein at least during step e), the invention comprises heating the membrane by means of the second heating element, controlling the temperature of the membrane through the second sensor for determining the mass flow rate diffusing through the membrane.

In another particular embodiment, after the deposition of the material on the substrate one or more substrates are heated by means of the third heating element for making the atoms deposited on the substrate or substrates uniform.

In a particular embodiment, the at least one membrane is made of an adsorbent material and wherein the membrane carries out a first step of adsorbing in the first space one or more materials of the feed compartment and a subsequent step of desorbing into the second space of the chamber controlled by the second heating element according to a particular embodiment of the first inventive aspect.

### Description of the Drawings

The foregoing and other features and advantages of the invention will be more clearly understood based on the following detailed description of a preferred embodiment provided only by way of illustrative and non-limiting example in reference to the attached drawings.
Figure 1 shows a schematic depiction of a particular embodiment of the apparatus according to the present invention.
Figures 2a-2b show the results obtained in a particular sublimation example according to the present invention.
Figure 3 shows the results obtained in a particular sublimation example according to the present invention.
Figure 4 shows the results obtained in a particular sublimation example according to the present invention.
Figures 5a-5b show the comparative results of a particular sublimation example according to the present invention.
Figure 6 shows a sublimation map of a particular example according to the present invention.
Figures 7a-7d show the results obtained in a particular sublimation example according to the present invention.

### Detailed Description of the Invention

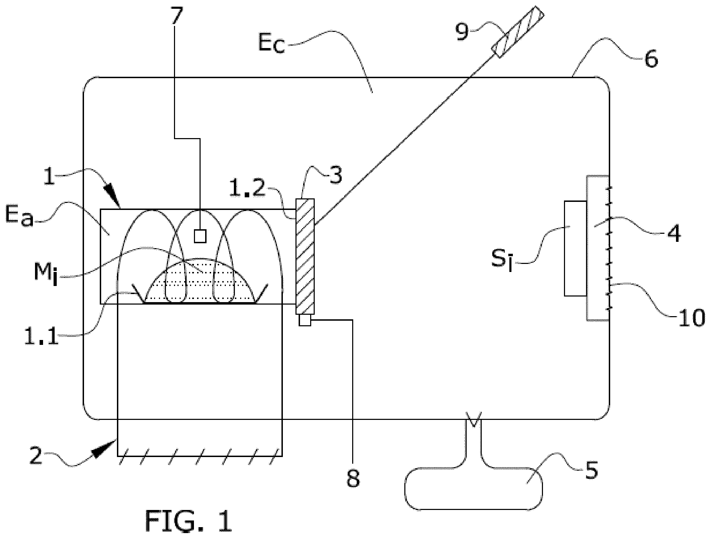

Figure 1 schematically shows a particular example of the apparatus for depositing materials on substrates under ultra-high vacuum conditions according to the present invention. As can be seen, the apparatus comprises a chamber (6) housing a feed compartment (1) or cell therein. The feed compartment (1) defines a first space (Eₐ) therein, whereas the chamber (6) defines therein a second space (E_{c}) which is under ultra-high vacuum conditions.

The feed compartment (1) has a first housing (1.1) therein in which the material Mᵢ to be deposited is housed. Furthermore, said feed compartment (1) is a partially closed receptacle comprising a window (1.2), wherein said window (1.2) is closed by a diffusion membrane (3).

The diffusion membrane (3) has two opposite faces, a first face in contact with the first space (Eₐ) of the feed compartment (1) and a second face in contact with the second space (E_{c}) of the ultra-high vacuum chamber (6).

In this embodiment, the feed compartment (1) is housed inside the chamber (6) and supported by structural fixing elements (not shown in the drawing), wherein it is furthermore configured for sublimation processes for the subsequent effusion of the material (Mᵢ) through the membrane (3) to take place therein.

The feed compartment (1) comprises a first heating element (2) arranged around said compartment (1), wherein this first heating element (2) is a resistance that is connected to a power supply element arranged outside the ultra-high vacuum chamber (6).

Furthermore, the feed compartment (1) comprises a first sensor (7) arranged on said compartment (1) such that it measures the temperature in the first space (Eₐ) in said feed compartment (1).

The membrane (3) comprises a second sensor (8) arranged on one of the ends of said membrane (3) such that it detects the temperature in the membrane (3).

According to this same embodiment, the chamber (6) also comprises a second housing (4) therein, in which a substrate (Sᵢ) on which the material (Mᵢ) is to be deposited is housed.

The second housing (4) of the ultra-high vacuum chamber (6) has in its lower part, in contact with one of the walls of the chamber (6), a third heating element (10) configured for heating the substrate (Sᵢ).

The apparatus further comprises a pump (5) which is located outside the chamber (6) and in communication with the inside of the second space (Ec). In this embodiment, the pump (5) has a first vacuum module for a first step of extracting gas from inside the chamber (6) and a second module formed by a molecular pump for producing the ultra-high vacuum conditions.

The apparatus further comprises a second heating element (9) which is a laser device. This laser device is located outside the ultra-high vacuum chamber (6) and is arranged to strike on the membrane (3) inside the ultra-high vacuum chamber (6), for example through, a window transparent to the wavelength of the laser beam. In another particular example (not shown in the drawings), the laser device is located inside the chamber (6).

Two sublimation examples for the sublimation of molecules in ultra-high vacuum using the apparatus equipped with a porous membrane (3) according to the present invention are shown below.

The porous membranes (P) used in these examples are selected from one of the following:
- P0 - Nominal pore size: 160-250 µm
- P1 - Nominal pore size: 100-160 µm
- P2 - Nominal pore size: 40-100 µm
- P3 - Nominal pore size: 16-40 µm
- P4 - Nominal pore size: 10-16 µm
- P5 - Nominal pore size: 1-1.6 µm

### Particular example 1

In this first example, hexabromobenzene (C₆Br₆) sublimation and activation conditions have been studied under three different experimental conditions: a) using an inert membrane-free receptacle, b) using tantalum (Ta) nanoparticles as a catalyst for activation in a membrane-free cell and c) using Ta nanoparticles in a cell equipped with a porous membrane (P) to increase the temperature and improve effusion selectivity.

In the particular case of hexabromobenzene, the catalytic debromination of aryl halides occurs at temperatures close to 100°C. However, it is impossible to reach these temperatures under UHV conditions without causing the uncontrolled sublimation of the molecules. For this reason, a sublimation cell with a porous membrane (P) has been used to achieve temperatures greater than 100°C in the receptacle or housing containing the molecules, maintaining acceptable sublimation flows and pressures in the feed compartment (1) throughout the entire experiment. On the other hand, the catalyst used for this debromation is Ta, added to the mixture of the material to be sublimated in the form of nanoparticles which at the same time increase the thermal conductivity of said mixture.

The experimental results obtained in each experiment are shown below:

### a) Sublimation of C₆Br₆ without the presence of catalyst or membrane

To study the sublimation conditions without the activation or delay caused by the membrane for reproducing the operating conditions according to the state of the art, quartz crucibles which are inert from the viewpoint of aryl halide chemistry were used.

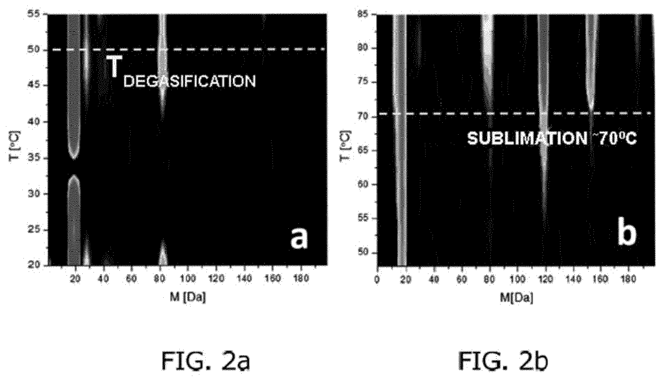

Figures 2a-2b show the spectra obtained in the mass quadrupole (M [Da]) as a function of temperature (T [ºC]) during the sublimation of C₆Br₆. Figure 2a shows a first degasification/*in-situ* purification process, and Figure 2b shows the subsequent sublimation with an inert crucible (quartz).

As a result, a molecule degasification temperature of around 50-55°C can be seen (according to the dotted line in Figure 2a), wherein above those temperatures the sublimation of C₆Br₆ effectively commences.

Furthermore, as can be seen, water (having a molecular mass of M18) and Br (having a molecular mass of M80) are the main impurities that appear during this process. The typical degasification process includes 24 hours at the selected temperature to assure the elimination of said impurities.

On the other hand, the appearance of ionization fragments corresponding to the sublimation of C₆Br₆ can be seen in Figure 2b after (about) 70°C. Signals of C₆CO₂ (with a molecular mass of M120), C₆Br (with a molecular mass of M 155) and C₆BrCO₂ (with a molecular mass of M196) are seen in particular.

### b) Sublimation of C₆Br₆ in the presence of catalyst without membrane

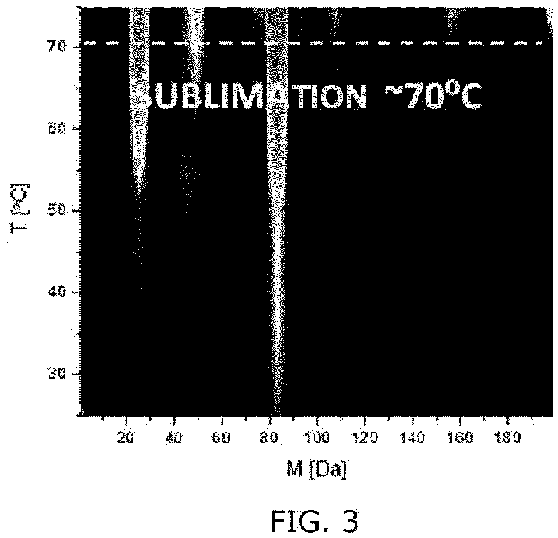

Figure 3 shows the spectra obtained in the mass quadrupole (M [Da]) as a function of temperature (T [ºC]) during the sublimation of C₆Br₆ in a quartz crucible, performed in the presence of Ta nanoparticles previously mixed with C₆Br₆, and also without the use of membrane for reproducing a mode of operation according to the state of the art.

As a result, the commencement of sublimation at temperatures also close to 70°C can be seen. However, it must be pointed out that heating is much more effective as a result of the greater thermal conductivity of the molecules/Ta mixture.

The main drawback found in this case is related to the total pressure in the chamber (6), which increases as the temperature in the crucible increases. So it is impossible to reach temperatures close to 100°C by maintaining acceptable sublimation pressures and flows.

It must be pointed out that according to this embodiment in accordance with the state of the art in which two spaces separated by a membrane do not exist, the pressure in the chamber (6) is the pressure established in the crucible.

### c) Sublimation of C₆Br₆ in the presence of a catalyst and a P4-type porous membrane

This is a first embodiment according to the invention with the presence of a membrane (3) establishing a separation between the first space (Eₐ) of the feed compartment and the second space (E_{c}) of the ultra-high vacuum chamber (6).

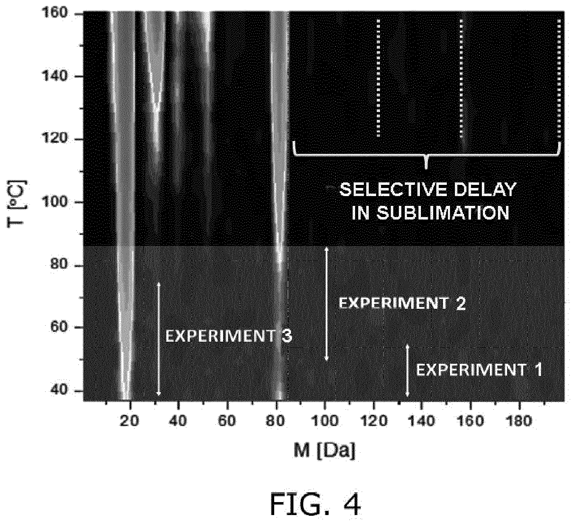

Figure 4 shows the spectra obtained in the mass quadrupole (M [Da]) as a function of temperature (T [ºC]) during the sublimation of C₆Br₆ measured in the first space (Eₐ) of the feed compartment (1) by means of the differential sublimation caused by the presence of the membrane (3) which allows an increased pressure without said pressure propagating to the chamber (6), said spectra being done in the presence of the catalyst and a P4-type inert porous membrane.

Furthermore, in Figure 4 the regions marked as experiment 1, experiment 2 and experiment 3 show the temperature range studied in experiments a) and b) shown in Figures 2a, 2b and 3, respectively.

The addition of a membrane (3) for the diffusion of the species in gas phase, i.e., a resistance to the passage of the sublimated species into the crucible, causes effective sublimation to occur at higher temperatures (in the case of this experiment, it is observed that sublimation occurs at 160°C for some species relating to C₆Br₆ decomposition).

Given that the selection of the membrane (3) depends on the molecular mass of the species involved in the sublimation of the material (Mᵢ), (the higher the molecular mass, the greater the resistance to Knudsen diffusion), a selective passage of said species is achieved. The *in-situ* purification process is therefore greatly improved (being possible to separate species and impurities of low molecular weight without the risk of the precursor molecules evaporating), while a higher temperature is achieved at the same time in the crucible to favor the chemical activation reaction therein.

Closing the first space (Eₐ) of the feed compartment (1) by means of a membrane (3) allows the sublimated gas to increase the pressure in said first space (Eₐ) without the pressure propagating to the second space (E_{c}), maintaining the ultra-high vacuum conditions. The increase in pressure in the first space (Ea) also causes the sublimation temperature of one and the same material to be higher, delaying it, such that the difference between the sublimation temperature of a material and the sublimation temperature of an impurity increases.

As a result, conditions in which the sublimation of each of the materials, included the impurities, occurs at different temperatures can be seen, so the sublimation of each component can be selectively delayed by raising the temperature gradually.

In addition to the selective delay in sublimation which allows carrying out effusion only in the moment in which the material which is being sublimated is the material of interest to be deposited, the membrane (3) or membranes (3) arranged in series or parallel also allow performing discrimination depending on the molecular weight of the sublimated material so that the molecules finally deposited on the substrate (Sᵢ) are the molecules of interest and not other molecules.

In this description, these positive effects caused by the presence of the membrane (3) between the first space (Eₐ) and the second space (E_{c}) are referred to as "effusion selectivity and delaying effect".

### Comparison of the sublimation results

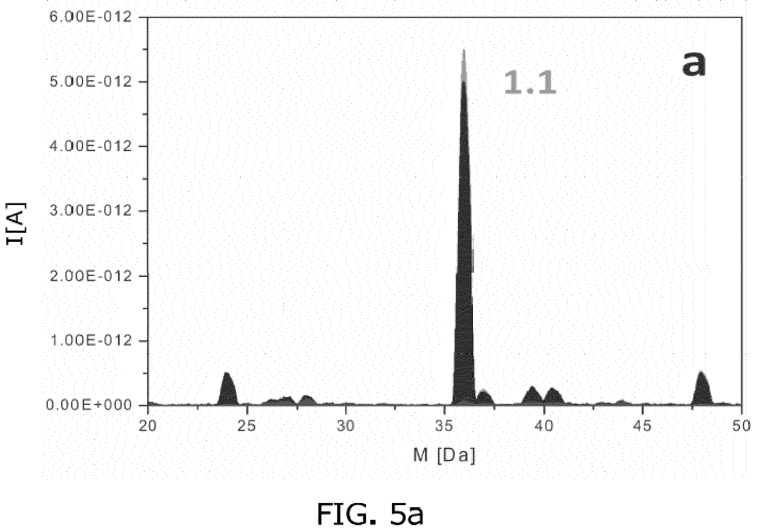

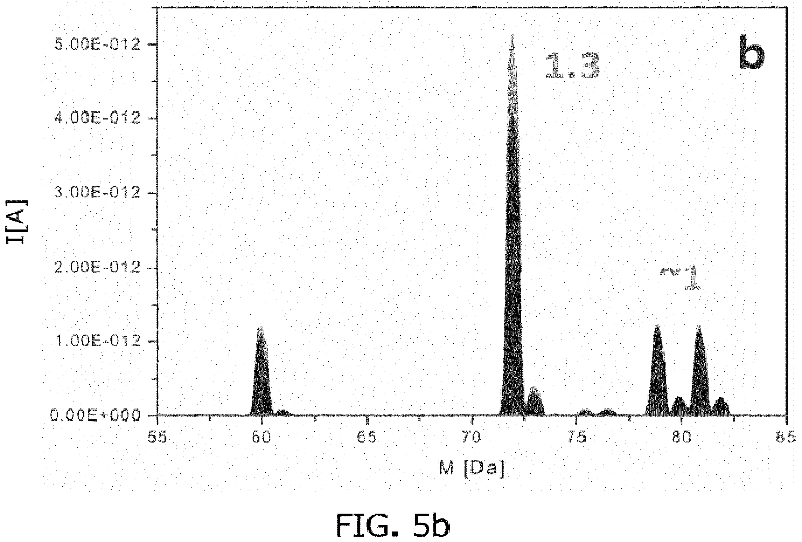

Figures 5a-5e show the spectra obtained in the mass quadrupole (M [Da] or Daltons) at 75ºC during the sublimation of C₆Br₆ in different experimental conditions. These drawings furthermore show the differences in the intensity (I [A]) of each molecular mass at 75ºC, the temperature at which sublimation occurs in the inert systems and with a catalyst (in the case of the porous membrane, this temperature does not show significant signals for C₆Br₆-related sublimation products).

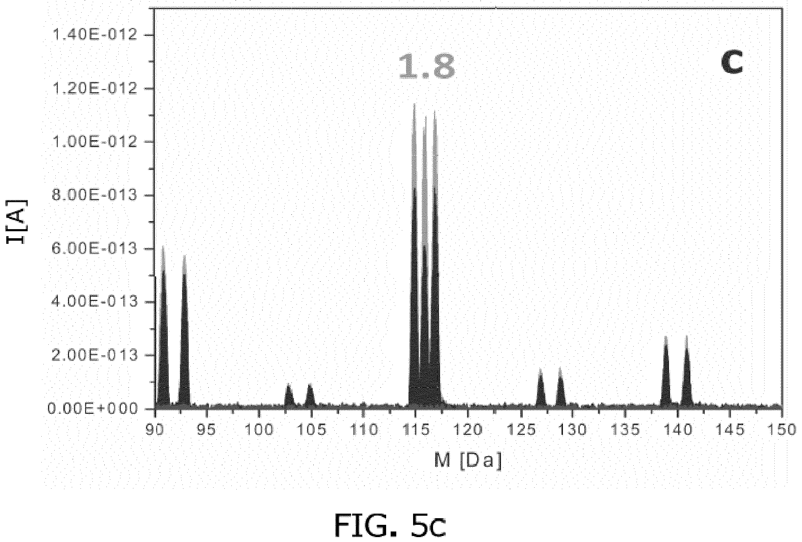

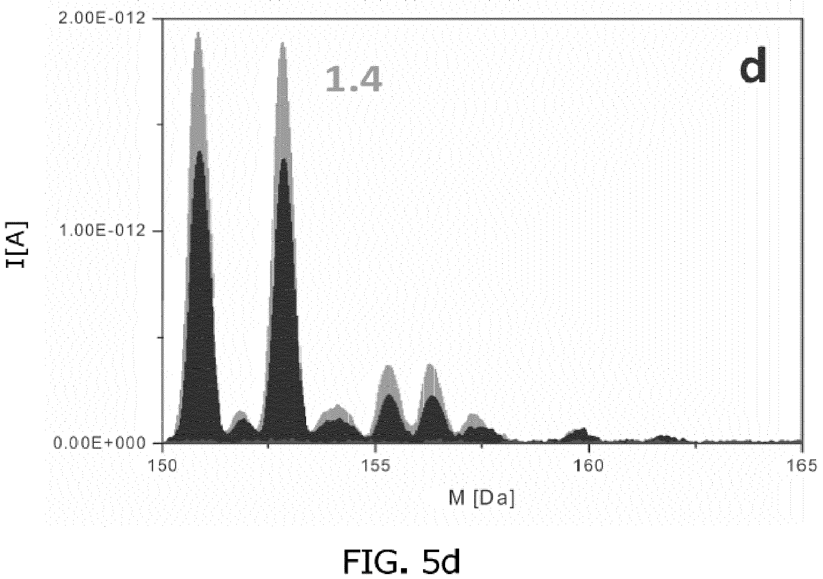

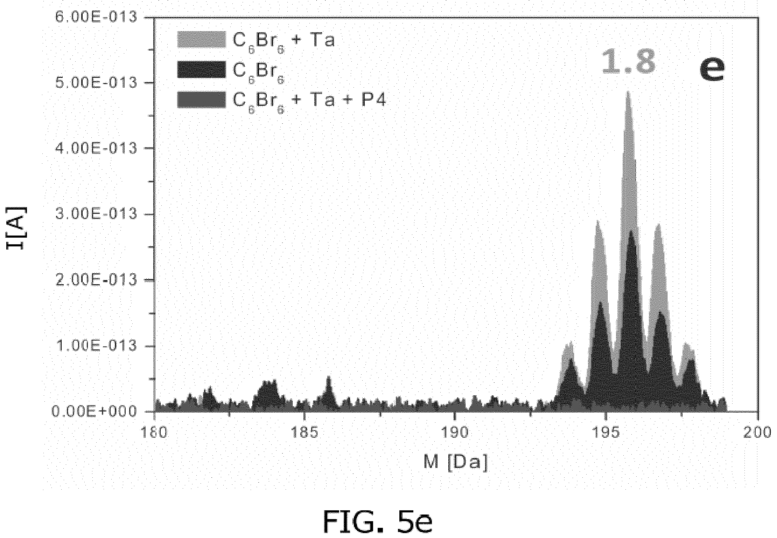

Figures 5a-5b show different regions of molecular masses, particularly, the 20-50 Da region (Figure 5a); the 55-85 Da region (Figure 4b); the 90-150 Da region (Figure 5c); the 150-165 Da region (Figure 5d); and the 180-200 Da region (Figure 5e). In these drawings, the numbers in light gray facing each peak represent the ratio between the (C₆Br₆+Ta) / (C₆Br₆) signals.

In these drawings, the numbers in light gray appearing together with each signal (in black) represent the ratio between the systems with catalyst (experiment b) and an inert system (experiment a). Furthermore, as can be seen there is a clear increase of molecular masses 72, 115, 150 and 195, whereas the mass 80 (bromine) does not record any changes.

On the other hand, in the tests with porous membrane it is observed that the signals obtained by the presence of molecules with a molecular weight up to 85 Da are detectable, whereas there is no record of greater masses, which indicates an increase in selectivity due to the use of the membrane.

### Sublimation map for C₆Br₆

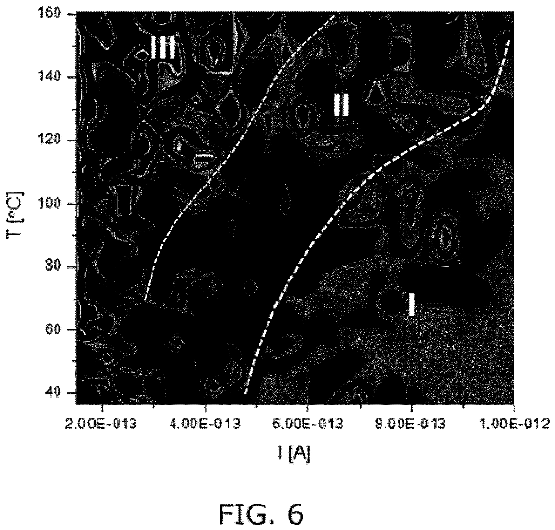

Figure 6 shows the sublimation map obtained in the working conditions (experiment c, Ta nanoparticles and P4-type membrane). This map was constructed with intensity (I [A]) of the signal of each molecular mass analyzed (from M1 to M199) as a function of temperature (T [ºC]) in a device with membrane (3) according to an embodiment of the invention.

Three zones can be identified in Figure 6: *in-situ* purification zone (zone I), degasification zone (zone II), and sublimation zone (zone III). Effusion is dominated by water and some gases in the air in zone I. The sublimation of gases such as nitrogen and oxygen takes place in zone II. The sublimation of C₆Br₆ precursor-related species, i.e., either the C₆Br₆ or any species resulting from its decomposition or the subsequent recombination of the decomposed molecules, commences in zone III. As can be seen, there is a M72 (benzene)-related signal which could be indicative of the completely debrominated (activated) precursors.

According to the result that is obtained, it can furthermore be pointed out that it is feasible to purify the system *in-situ* and to then attain the molecule activation temperature without contaminating the chamber (6). Furthermore, the membrane (3) allows separating the fragments of different molecular masses (once the reaction has occurred).

### Particular example 2

In this second example, the effects of delaying and modifying the effusion selectivity obtained during the sublimation of indole carboxylic acid (C₉H₇NO₂) with different porous membranes have been studied.

In this example, indole carboxylic acid was used as measurement standard for sublimation experiments with porous membranes due to its relatively low molecular mass (161 Da) and its affinity to impurities such as water.

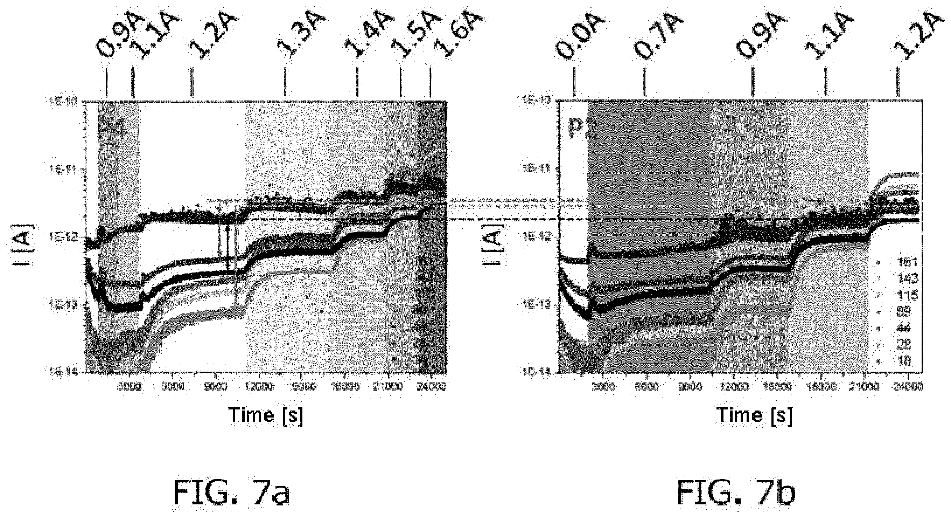

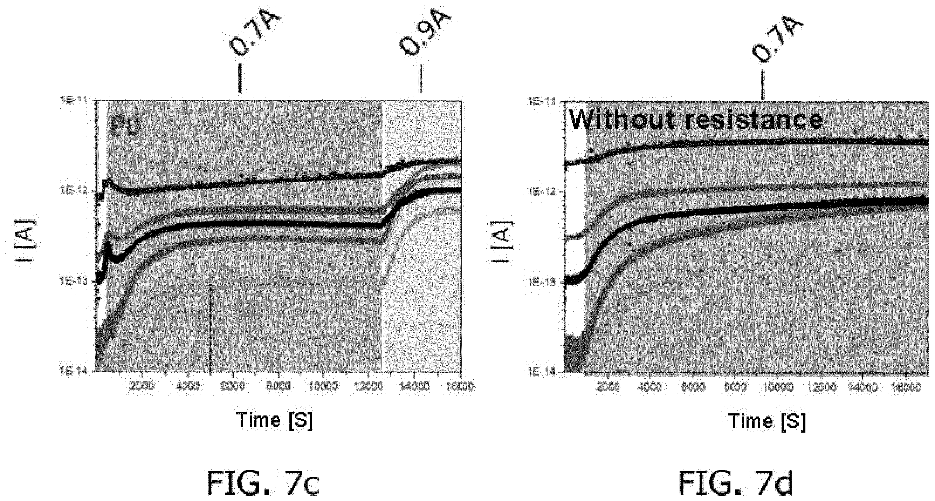

Experiments were conducted with C₉H₇NO₂ at different temperatures to study the selectivity and delaying effect in the effusion of species through the membranes (3). The membranes (3) used are of different types: P4-type membrane (Figure 7a), P2-type membrane (Figure 7b), P0-type membrane (Figure 7c) and without membrane (without resistance, Figure d) for reproducing an experiment according to the state of the art.

Figures 7a-7d show the concentrations of molecular masses 18, 28, 44, 89, 115, 143 and 161 (water, nitrogen, carbon dioxide and C₉H₇NO₂ fragments in the chamber) over time (time [s]) as the temperature in the first space (Eₐ) increases. It is observed that the ratio of molecular masses appearing in this experiment changes depending on the porosity of the membrane (3), the smaller the pore size, the greater the delaying effect (less effusion at the same temperature) and the greater the selectivity (less effusion of larger molecular masses).

In these drawings, the different color intensities (black to gray) correspond to different current values (I [A]) in the heating (and temperature) resistance.

## Claims

**1.** An apparatus for depositing one or more materials (Mᵢ) on one or more substrates (Sᵢ) under ultra-high vacuum conditions, **characterized in that** it comprises:
- a feed compartment (1) defining a first space (Eₐ) therein and comprising a first housing (1.1) for the at least one material (Mᵢ),
- a first heating element (2) for the sublimation of the at least one material (Mᵢ) housed in the feed compartment (1),
- an ultra-high vacuum chamber (6) defining a second space (E_{c}) therein, wherein the ultra-high vacuum chamber (6) comprises a second housing (4) for at least one substrate (Sᵢ),
- a pump (5) in communication with the second space (E_{c}) of the chamber (6) for producing ultra-high vacuum in said second space (E_{c}),
wherein
the feed compartment (1) comprises a window (1.2) closed by at least one diffusion membrane (3) for the at least one material (Mᵢ), said diffusion membrane (3) comprises two opposite faces, a first face in contact with the first space (Eₐ) of the feed compartment (1) and a second face in contact with the second space (E_{c}) of the ultra-high vacuum chamber (6).

**2.** The apparatus according to claim 1, wherein the at least one diffusion membrane (3) is a porous material with interconnected pores.

**3.** The apparatus according to claim 2, wherein the pores of the at least one diffusion membrane (3) have a size between 10 nm and 400 µm.

**4.** The apparatus according to any of claims 1 to 3, wherein the at least one diffusion membrane (3) is a Knudsen diffusion membrane for the at least one material (Mi).

**4.** The apparatus according to any of the preceding claims, wherein the at least one membrane (3) is made of an adsorbent material such that said at least one membrane (3) is adapted to adsorb the at least one material (Mᵢ) from the first space (Eₐ) and to desorb said material (Mᵢ) into the second space (E_{c}).

**5.** The apparatus according to any of the preceding claims, comprising a plurality of diffusion membranes (3; Fᵢ, i=1,..,n) arranged in series, wherein there is a gap (Eᵢ, i=1,..,n-1) between consecutive membranes Fᵢ, Fᵢ₊₁.

**6.** The apparatus according to any of claims 1 to 4, comprising a plurality of diffusion membranes (3; Fᵢ, i=1,..,n) arranged in series, wherein each membrane is in contact with the adjacent membrane.

**7.** The apparatus according to any of the preceding claims, wherein one or more groups of diffusion membranes (3) are arranged parallel to one another.

**8.** The apparatus according to any of the preceding claims, wherein the feed compartment (1) is housed inside the chamber (6).

**9.** The apparatus according to any of the preceding claims, wherein the at least one diffusion membrane (3) is an inert membrane.

**10.** The apparatus according to any of claims 1 to 8, wherein the at least one diffusion membrane (3) is an active membrane.

**11.** The apparatus according to claim 10, wherein the at least one active diffusion membrane (3) is made of an inert material with active particles.

**12.** The apparatus according to any of the preceding claims, wherein the feed compartment (1) further comprises a first sensor (7) configured for detecting temperature in the first space (Eₐ) inside said feed compartment (1).

**13.** The apparatus according to any of the preceding claims, wherein the at least one diffusion membrane (3) further comprises a second sensor (8) configured for detecting temperature in said at least one membrane (3).

**14.** The apparatus according to any of the preceding claims, wherein the at least one diffusion membrane (3) further comprises a second heating element (9) configured for desorbing the at least one material (Mᵢ), preferably said second heating element (9) is a laser device arranged to strike on the at least one membrane (2).

**15.** A method for depositing one or more materials (Mᵢ) on one or more substrates (Sᵢ) under ultra-high vacuum conditions by means of the apparatus according to claim 1 to 14, **characterized in that** it comprises the following steps:
a) placing one or more deposition materials (Mᵢ) in the housing (1.1) of the feed compartment (1),
b) placing one or more substrates (Sᵢ) in the housing (4) of the ultra-high vacuum chamber (6),
c) applying vacuum in the chamber (6) by means of the pump (5),
d) heating the feed compartment (1) by means of the first heating element (2) until reaching the sublimation temperature of one or more materials (Mᵢ) in the first space (Eₐ),
e) maintaining the sublimation temperature for a deposition time until the diffused material is projected onto one or more substrates (Sᵢ).
